(19) Europäisches Patentamt
European Patent Office
Office européen des brevets

(11) **EP 0 905 898 B1**

(12) **EUROPEAN PATENT SPECIFICATION**

(45) Date of publication and mention
of the grant of the patent:
**30.10.2002 Bulletin 2002/44**

(51) Int Cl.7: **H03K 17/06**

(21) Application number: **98112919.0**

(22) Date of filing: **11.07.1998**

(54) **An improved apparatus for current pulse generation in voltage down converters**

Verbessertes Gerät zur Stromimpulserzeugung in Abwärts-Spannungswandlern

Appareil amélioré pour la génération d'impulsions de courant dans des convertisseurs abaisseurs de tension

(84) Designated Contracting States:
**DE FR GB IE IT NL**

(30) Priority: **25.09.1997 US 937763**

(43) Date of publication of application:
**31.03.1999 Bulletin 1999/13**

(73) Proprietor: **SIEMENS AKTIENGESELLSCHAFT**
**80333 München (DE)**

(72) Inventor: **Weinfurtner, Oliver**
**Wappingers Falls, NY 12590 (US)**

(74) Representative: **Patentanwälte**
**Westphal, Mussgnug & Partner**
**Waldstrasse 33**
**78048 Villingen-Schwenningen (DE)**

(56) References cited:
**EP-A- 0 785 494          US-A- 4 857 769**

• **PATENT ABSTRACTS OF JAPAN vol. 9, no. 54 (P-340), 8 March 1985 (1985-03-08) & JP 59 191627 A (HITACHI), 30 October 1984 (1984-10-30)**

**Description**

**BACKGROUND**

**1. Technical Field**

This disclosure relates to electronic circuits and more particularly, to an adjustment circuit for a MOSFET switch.

**2. Description of the Related Art:**

Generally, a semiconductor memory device comprises memory blocks for storing a plurality of binary information and memory peripheral circuits for driving the memory blocks. The memory device further comprises at least one voltage down converter for converting a supply voltage from an external power supply circuit to a desired level and supplying the converting voltage to an internal circuit which includes the memory blocks and the memory peripheral circuits. This down converting is necessary to ensure the reliability of the transistors by providing a lower power of operation.

Since components in the semiconductor device are micronized (generally about .5 microns or less), the reliability of the transistors would be greatly reduced if the full supply voltage were used to drive them. Reliability problems would arise in the form of breakdown of insulating films of metal oxide semiconductor field effect transistors (MOSFET's).

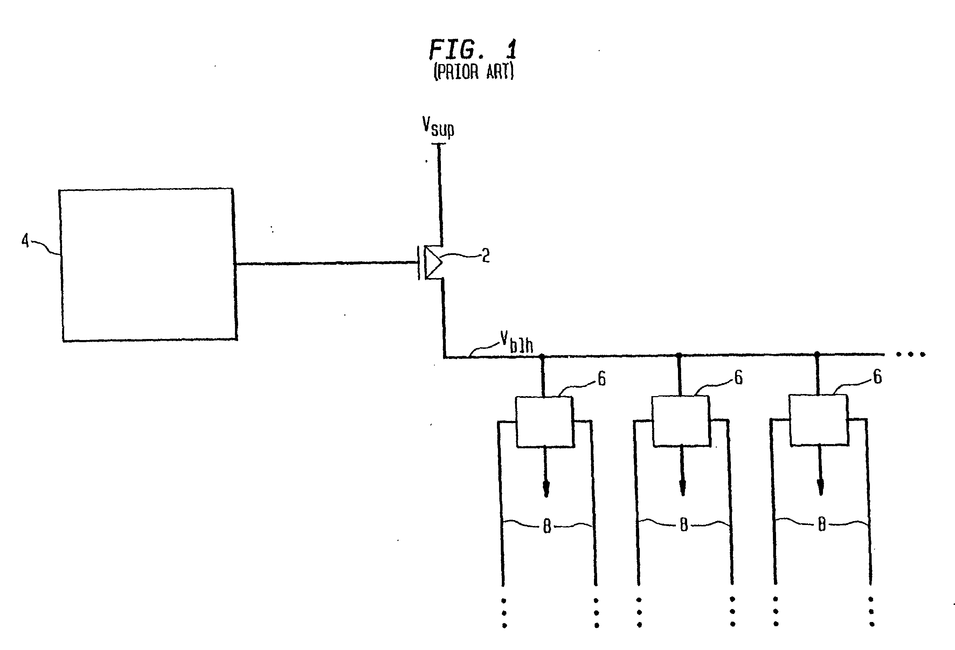

A simple and area efficient way to create current pulses'in voltage down converters is to use a MOSFET switch that is controlled by a timer circuit. Referring to FIG. 1, a prior art scheme is shown for a voltage down converter. MOSFET switch 2 has its source and drain connected between supply voltage $V_{sup}$ and bit line high voltage $V_{blh}$. MOSFET switch 2 is controlled by a timer circuit 4. Generally, MOSFET switch 2 is synchronized with sense amplifiers 6 through timer circuit 4. Timer circuit 4 turns on MOSFET switch 2 for a preset amount of time. This allows a fixed amount of charge to flow from node $V_{sup}$ to node $V_{blh}$. The sense amplifiers 6 sense a voltage differential between two complementary bit lines 8 of the memory block. When a difference is sensed by a sense amplifier, one of the two bit lines is brought high and the other is brought low. Low is generally ground potential where as high is Vblh. Ideally the amount of charge that flows through MOSFET switch 2 is identical to the amount of charge consumed by sense amplifiers 6 during the activation period.

The disadvantage of this scheme is the strong dependency of the transistor current on the parameters of the circuit, especially the threshold voltage of the MOSFET switch 2. A variation of $V_T$ has a major influence on the current that is produced by the MOSFET switch 2.

Threshold voltage of a transistor is a function of many parameters including manufacturing processes, doping levels for the sources and drains, etc. In order to reduce the effects of threshold voltage variations on MOSFET switches it is necessary to compensate for these parameters. Thus, a need exists for an improved circuit which can account for variations in the threshold voltage of a MOSFET switch.

**Summary of the Invention**

A voltage converter circuit for an electronic device includes a transistor switch for providing current pulses to a current input node. The transistor switch has a gate and a turn-on threshold voltage. An adjustment circuit provides a controlled voltage to the gate for turning on the transistor switch and the adjustment circuit includes means for compensating for variations in the turn-on threshold voltage of the transistor switch. A timer for enables the adjustment circuit for a preset period of time.

In one embodiment, the transistor switch is a metal oxide semiconductor field effect transistor (MOSFET). In another embodiment, the adjustment circuit contains a transistor having a threshold voltage substantially equal to the threshold voltage of the transistor switch. The adjustment circuit may also include a voltage divider circuit. The voltage divider circuit has at least one resistor which can be dimensioned to adjust the gate voltage of the transistor switch. In another embodiment, the voltage divider circuit includes at least one transistor having a threshold voltage substantially the same as the transistor switch.

An adjustment circuit for a semiconductor memory devices includes a first node, a second node for connecting to a gate of a MOSFET switch and a feedback circuit connected to the first and second nodes for monitoring voltage changes at the first node and adjusting voltage at a second node to compensate for variations in current flow through the MOSFET switch. In an alternate embodiment, the feedback circuit further includes a differential amplifier to supply a substantially constant voltage to the first node, a resistor connected between the first node and ground such that a constant current flows through a first transistor, the first transistor having a gate connected to the second node. The first transistor and the MOSFET switch can both be either PMOSFET's or NMOSFET's with a threshold voltage substantially equal to the threshold voltage of the MOSFET switch.

**Brief Description of Drawings**

Various embodiments will be described in detail in the following description of preferred embodiments with reference to the following figures wherein:

FIG. 1 shows a schematic diagram of a prior art MOSFET switch that is controlled by a timer circuit;
FIG. 2 shows a schematic/block diagram of an adjustment circuit enabled by a timer circuit and connected to a MOSFET switch;
FIG. 3 is a schematic diagram of an embodiment of an adjustment circuit connected to a MOSFET switch;
FIG. 4 is a schematic diagram of an alternate embodiment of the embodiment shown in FIG. 3 showing a plurality of transistors in series added to an adjustment circuit; and
FIG. 5 is a schematic diagram of another embodiment of an adjustment circuit showing a differential amplifier. and a feedback loop used in conjunction with a MOSFET switch.

**Detailed Description of the Invention**

The present disclosure describes an adjustment circuit for minimizing effects due to the threshold voltage variations for a metal oxide semiconductor field effect transistor (MOSFET) switch. The MOSFET switch includes a timer for closing the switch for a preset period of time. This is useful for applications such as when sense amplifiers of a dynamic random access memory (DRAM) chip sense a differential voltage between a corresponding pair of bit lines. The switch connects between the supply voltage node and a bit line high voltage node. When the switch is activated current flows through the switch to sense amplifiers which are connected to complementary pairs of bit lines.

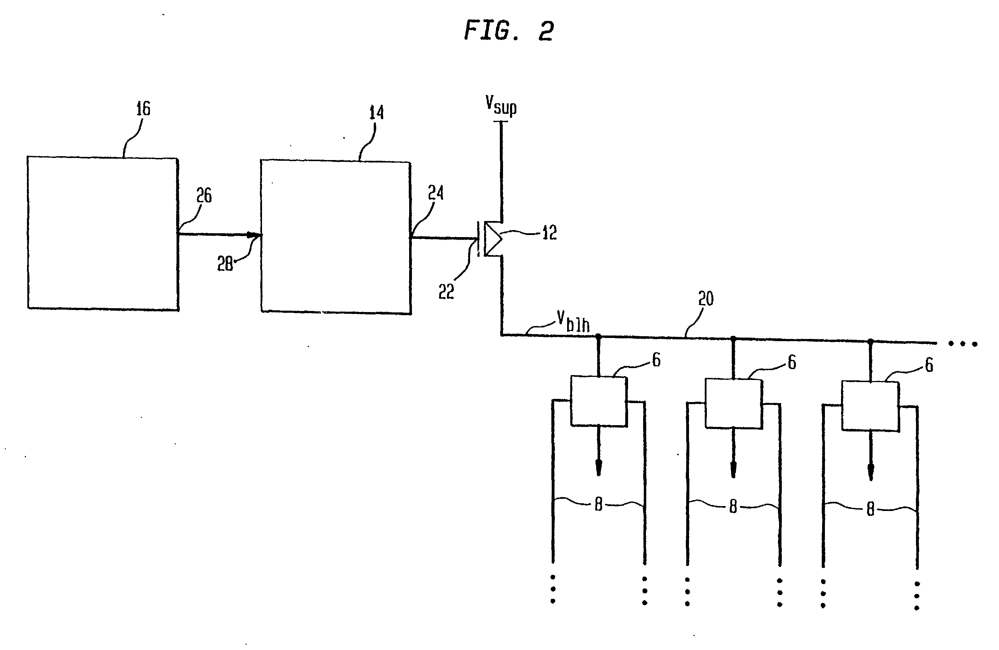

Referring now in specific detail to the drawings in which like reference numerals identify similar or identical elements throughout the several views, and initially to FIG. 2, a block diagram of a circuit of the present invention is shown. A timer circuit 16 sends a signal from a timer output 26. An adjustment circuit 14 is connected to timer output 26 at adjustment circuit input 28. The signal from output 26 enables adjustment circuit 14. Adjustment circuit 14 adjusts the voltage to an adjustment circuit output 24. A MOSFET switch 12 has a gate 22 connected to adjustment circuit output 24. When the adjusted voltage is applied to gate 22, current flows through switch 12 into the $V_{blh}$ node 20. $V_{blh}$ supplies sense amplifiers to drive one of the complementary pair of bit lines 8 high. Adjustment circuit 14 is designed to provide gate 22 with appropriate voltage to allow a predetermined amount of current flow through MOSFET switch 12 to provide enough current to sense amplifiers 6 during activation. Although shown as a PMOSFET, MOSFET switch may also be an NMOSFET.

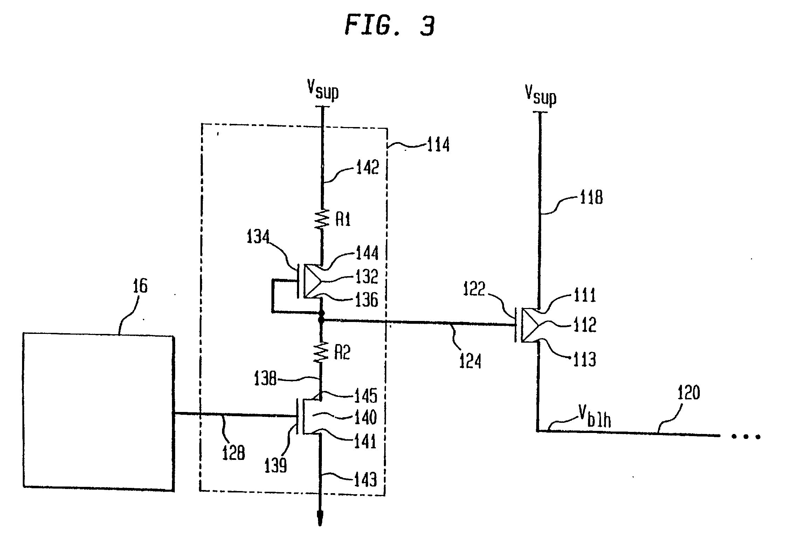

Referring to FIG. 3, an adjustment circuit 14 in accordance with one embodiment of the invention is schematically illustrated. Adjustment circuit 114 has an input 128 from a timer circuit 16. Input 128 is connected to a gate 139 of a transistor 140, for example a MOSFET. Transistor 140 acts as an activation switch for the adjustment circuit 114. When the appropriate signal is received from timer circuit 16, gate 139 is activated allowing current to flow through transistor 140.

Transistor 140 has its drain 141 connected to ground 143 and its source 145 connected to node 138. A resistor $R_2$ is connected between node 138 and a node 124. Node 124 is connected to a transistor 132, preferable a PMOSFET.

Transistor 132 has a source 144, a gate 134 and a drain 136. Both gate 134 and drain 136 are connected to node 124. Resistor $R_1$ connects between source 144 of transistor 132 and a node 142. Node 142 is at the supply voltage $V_{sup}$ potential.

Node 124 is connected to a gate 122 of a transistor switch 112. Transistor switch 112 is preferably a MOSFET. Transistor switch 112 has a source 111 and a drain 113. Drain 113 is connected to $V_{blh}$ node 120, and source 111 is connected to node 118 which remains at the supply voltage $V_{sup}$ potential. It is preferred to have switch 112 be of the same kind as transistor 132, i.e. both of the transistors(112, 132) are PMOSFET's or both of the transistors (111, 132) are NMOSFET's. Preferably, transistor 132 and transistor switch 112 can share the same doped regions for their respective sources 111, 144 and drains 113, 136. In this way the threshold voltage $V_T$ across the transistor (the voltage difference between the source and drain of a transistor) is the same for both transistor 132 and transistor switch 112.

The resistors $R_1$ and $R_2$ and transistor 132 act as a voltage divider circuit. Timer circuit 16 sends an enable signal to input 128 which applies a voltage to gate 139. This allows current to flow from node 138 to ground 143.This current draw causes current flow through resistor $R_1$ creating a potential drop across the resistor $R_1$. This voltage is applied to gate 134 of transistor 132 allowing current to flow through resistor $R_2$ as well. The voltage at node 124 can be calculated as follows:

**EP 0 905 898 B1**

$$V_{node124} = \frac{V_{sup} - V_T}{R_1 + R_2} \times R_2$$

$V_{node124}$ is the applied voltage to gate 122. The voltage $V_{node124}$ that is applied to the gate 122 is sufficient to allow current to flow from source 111 to drain 113. It is important that the charging current that passes through switch 112 be sufficient to enable operation of the sense amplifiers 6 during their activation period. As such, the voltage $V_{node124}$ that is applied to the gate 122 is sufficiently high to achieve this goal. Since transistor 132 and switch 112 share the same doped regions for their respective sources 111, 144 and drains 113, 136, any threshold voltage $V_T$ changes across the transistors 112, 132 are the same. If, for example, the threshold voltage $V_T$ of transistor 132 and switch 112 is increased, then their current flow from source 111, 114 to drain 113, 136 decreases. Consequently, the voltage $V_{node124}$ at node 124 changes according to the formula:

$$V_{node124} + delta\ V_{node124} = \frac{V_{sup} - (V_T + delta\ V_T)}{R_1 + R_2} \times R_2$$

where:

delta $V_{node124}$ represents the change voltage differential from the voltage $V_{node124}$ prior to the increased threshold voltage $V_T$; and

delta $V_T$ represents the increase in threshold voltage $V_T$ across the transistors 132, 112.

The gate voltage of switch 112 is decreased and by this, the current flow from source 111 to drain 113 is increased. The combination of these two effects leads to reduced influence of the threshold voltage variations on the current flow through switch 112. The value of the voltage $V_{node124}$ can be controlled by dimensioning the resistors $R_1$ and $R_2$.

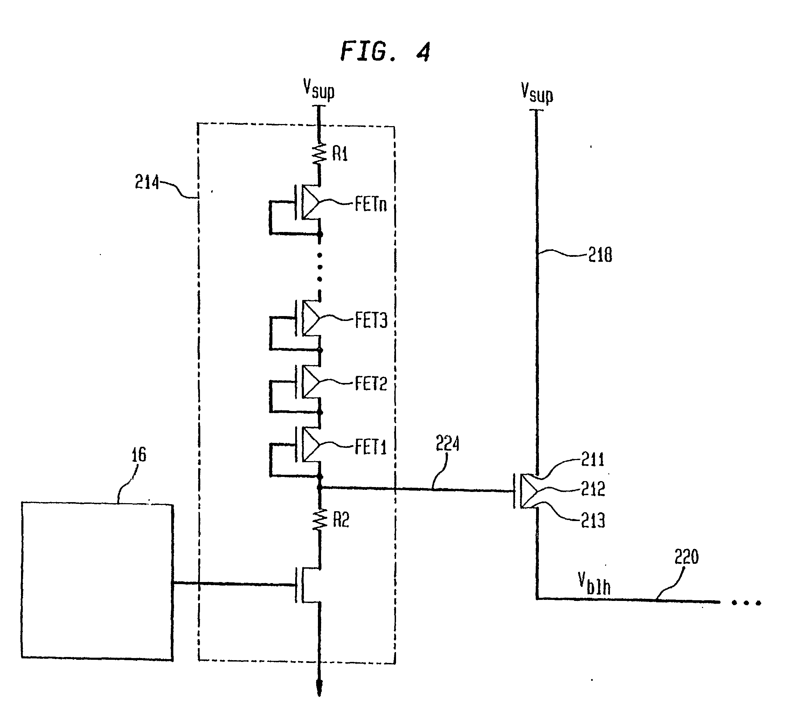

Referring to FIG. 4, another embodiment of the adjustment circuit includes the addition of transistors to further reduce the influence of threshold voltage changes on switch 112. A plurality of transistors designated as FET1 through FETn are connected serially between resistor $R_1$ and node 224. Each transistor is preferably the same type as a transistor switch 212, i.e. all transistors are PMOSFET's, or all NMOSFET's. Each of the plurality of transistors FET1 through FETn has its drain connected to its gate. It is preferred to have all the sources and drains of the transistors FET1 through FETn share the same doped regions for their respective sources and drains so that any threshold voltage $V_T$ changes across the transistors are the same for each transistor. The compensation effect on switch 212 is increased. This means that the voltage at node 224 is more reliably achieved making the current flow rate through switch 224 more efficient and repeatable. If n is used to denote the number of transistors FET1, FET2, FET3 ... FETn used, the voltage at node 224 can be calculated according to the following formula:

$$V_{node224} + delta\ V_{node224} = \frac{V_{sup} - (V_T + (n \times delta\ V_T))}{R_1 + R_2} \times R_2$$

where:

delta $V_{node224}$ represents the change voltage differential from the voltage prior to the increased threshold voltage $V_T$;

n is the number of transistors introduced in series; and

delta $V_T$ represents the increase in threshold voltage $V_T$ across the transistors.

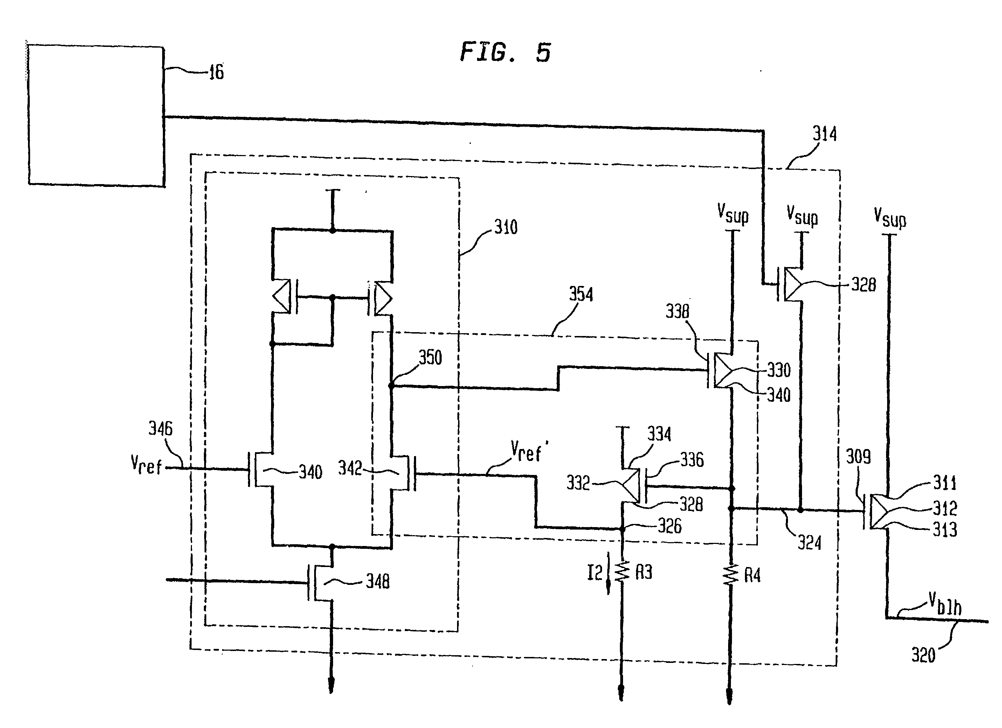

Referring to FIG. 5, another embodiment of an adjustment circuit 314 includes a two stage differential amplifier 310. An input 346 to differential amplifier 310 is at reference voltage $V_{REF}$. Differential amplifier 310 maintains voltage $V_{REF'}$ at a node 326. A feedback circuit 354 includes a transistor 342 of differential amplifier 310, a transistor 332, a transistor 330 and node 350, node 326 and node 324. Since the voltage at node 326 is held constant by differential amplifier 310, the current $I_2$ through resistor $R_3$ is constant:

$$I_2 = V_{REF}' / R_3.$$

Transistor 332 is used to track changes in threshold voltage $V_T$ and to adjust the voltage in node 324 accordingly. Transistor 332 has a source 334, gate 336 and a drain 328. Drain 328 is connected to node 326 and gate 336 is connected to node 324. Transistor 330 connects node 350 to node 324 to complete feedback circuit 354. Transistor 330 has its gate 338 connected to node 350 and its drain 340 connected to node 324. If, for example, the threshold voltage $V_T$ of transistor 332 increases, the voltage at node 324 is lowered in order to maintain the constant voltage $V_{REF}'$ at node 326 ($I_2 = V_{REF}' / R_3$). Feedback circuit 354 adjusts the voltage of gate 336 to maintain current $I_2$ constant. This means that the voltage at node 324 is compensated for variations in the threshold voltage $V_T$ in transistor 332, maintaining a predetermined voltage at node 324. Resistor $R_4$ keeps the voltage at node 324 regulated by allowing current from transistor 330 to flow to ground.

Transistors 332 and transistor switch 312 are of the same type, i.e. all PMOSFET's, or all NMOSFET's. So that tracking threshold voltage variations can be achieved in transistor switch 312. It is preferred that transistor 332 and transistor switch 312 are made to share the same doped region of the chip. It is desired to achieve similar current densities in transistor 332 and transistor switch 312. The transition voltages would therefore be nearly the same for these transistors, hence threshold voltage variations can be more closely tracked.

A transistor 328 receives an enable signal from timer circuit 16 begins the activation cycle in which current flows through transistor switch 312 from supply voltage $V_{sup}$. Node 324 is connected to a gate 309 of switch 312. This allows current to flow from $V_{sup}$ toward bit line high voltage $V_{blh}$. Since the voltage at node 324 is compensated, effects due variations in threshold voltages $V_T$ are minimized, thereby improving the performance and efficiency of transistor switch 312.

While this invention has been described in terms of several illustrative embodiments, there are alterations, permutations, and equivalents which fall within the scope of this invention, as defined in the claims.

## Claims

1. A voltage converter circuit comprising: a transistor switch (12, 112, 212, 312) for providing current pulses to a current input node (20, 120, 220, 320), the transistor switch (12, 112, 212, 312) having a gate (22, 122, 309) and a turn-on threshold voltage $V_T$;
   **characterized in**
   an adjustment circuit (14, 114, 214, 314) for providing a controlled voltage to the gate (22, 122, 309) for turning on the transistor switch (12, 112, 212, 312) and having means for compensating for variations (delta $V_T$) in the turn-on threshold voltage ($V_T$) of the transistor switch (12, 112, 212, 312); and a timer (16) for enabling the adjustment circuit (14, 114, 214, 314) for a preset period of time.

2. The voltage converter circuit as recited in claim 1, **characterized in that** the transistor switch (12, 112, 212, 312) is a MOSFET (12, 112, 212, 312).

3. The voltage converter circuit as recited in claim 1 **characterized in that** the adjustment circuit (114, 214) contains a transistor (132, FET1, FET2, FET3...FETn) having a turn-on threshold voltage ($V_T$) substantially equal to the turn-on threshold voltage ($V_T$) of the transistor switch (112, 212).

4. The voltage converter circuit as recited in claim 1 **characterized in that** the adjustment circuit (114, 214) includes a voltage divider circuit ($R_1$, $R_2$, 132, FET1, FET2, FET3...FETn).

5. The voltage converter circuit as recited in claim 4, characterized the voltage divider circuit ($R_1$, $R_2$, 132, FET1, FET2, FET3...FETn) has at least one resistor ($R_1$, $R_2$) which can be dimensioned to adjust the gate voltage ($V_{node124}$, $V_{node224}$) of the transistor switch (112, 212).

6. The voltage converter circuit as recited in claim 4, **characterized in that** the voltage divider circuit ($R_1$, $R_2$, 132) includes at least one transistor (132, FET1, FET2, FET3...FETn) having a threshold voltage ($V_T$) substantially the same as the transistor switch (112, 212).

7. The voltage converter circuit as recited in claim 4, **characterized in that** the voltage divider circuit ($R_1$, $R_2$, 132, FET1, FET2, FET3...FETn) includes at least one transistor (132, FET1, FET2, FET3...FETn) having a source (114) and a drain (136), and the transistor switch (112, 212) has a source (111) and a drain (113) wherein the sources (144, 111) and drains (136, 113) share doped regions.

8. The voltage converter circuit as recited in claim 1 or 2, **characterized in that** the adjustment circuit (314) comprises:

a first node (326);

a second node for connecting to the gate of the transistor switch (312);

a feedback circuit (354) connected to the first and second nodes (326, 324) for monitoring voltage changes at the first node (326) and adjusting voltage at the second node (324) to compensate for variations in current flow through the transistor switch (312).

9. The voltage converter circuit as recited in claim 8 characterized in that' the feedback circuit (354) further comprises a differential amplifier (310) to supply a substantially constant voltage ($V_{REF}$ ') to the first node (326), a resistor ($R_3$) connected between the first node (326) and ground such that a constant current ($I_2$) flows through a first transistor (332), the first transistor (332) having a gate (336) connected to the second node (324).

10. The voltage converter circuit as recited in claim 9, **characterized in that** the first transistor (332) and the transistor switch (312) are PMOSFETs.

11. The voltage converter circuit as recited in claim 9, **characterized in that** the first transistor (332) and the transistor switch (312) are NMOSFETs.

12. The voltage converter circuit as recited in claim 9, 10, or 11, **characterized in that** the first transistor (332) has a threshold voltage ($V_T$) substantially equal to the threshold voltage ($V_T$) of the transistor switch (312).

13. The voltage converter as recited in one of claims 9 to 12, **characterized in that** the first transistor (332) has a source (334) and a drain (328), the transistor switch (312) has a source (311) and a drain (313) wherein the sources (334, 311) and drains (328, 313) share doped regions.

14. The voltage converter circuit as recited in one of the clais 1 to 13, **characterized in that** the voltage converter circuit is a semiconductor memory device voltage down converter.

15. Semiconductor memory comprising a voltage converter circuit according to one of the previous claims.

**Patentansprüche**

1. Spannungswandler mit
einem Schalttransistor (12, 112, 212, 312), welcher Stromimpulse an einen Stromeingangsknoten (20, 120, 220, 320) liefert, wobei der Schalttransistor (12, 112, 212, 312) einen Gate-Anschluss (22, 122, 309) und eine Anschalt-Schwellenspannung $V_T$ aufweist,
**gekennzeichnet durch**

eine Regelungsschaltung (14, 114, 214, 314) zur Bereitstellung einer kontrollierten Spannung für den Gate-Anschluss (22, 122, 309), um den Schalttransistor (12, 112, 212, 312) einzuschalten, und welche eine Vorrichtung zum Ausgleich von Schwankungen (delta $V_t$) in der Anschalt-Schwellenspannung ($V_T$) des Schalttransistors (12, 112, 212, 312) aufweist; und
einem Zeitgeber (16), welcher die Regelungsschaltung (14, 114, 214, 314) für eine vorgegebene Zeitspanne freigibt.

2. Spannungswandler nach Anspruch 1, **dadurch gekennzeichnet, dass** der Schalttransistor (12, 112, 212, 312) ein MOSFET (12, 112, 212, 312) ist.

3. Spannungswandler nach Anspruch 1, **dadurch gekennzeichnet, dass** die Regelungsschaltung (114, 214) einen Transistor (132, FET1, FET2, FET3...FET$_n$) enthält, welcher eine Anschalt-Schwellenspannung ($V_T$) aufweist, die im Wesentlichen der Anschalt-Schwellenspannung ($V_T$) des Schalttransistors (112, 212) entspricht.

**4.** Spannungswandler nach Anspruch 1, **dadurch gekennzeichnet, dass** die Regelungsschaltung (114, 214) einen Spannungsteiler ($R_1$, $R_2$, 132, FET1, FET2, FET3...FET$_n$) beinhaltet.

**5.** Spannungswandler nach Anspruch 4, **dadurch gekennzeichnet, dass** der Spannungsteiler ($R_1$, $R_2$, 132, FET1, FET2, FET3...FET$_n$)zumindest einen regelbaren Widerstand ($R_1$, $R_2$) aufweist, um die Gate-Anschluss-Spannung ($V_{node\ 124}$, $V_{node\ 224}$) des Schalttransistors (112, 212) anzupassen.

**6.** Spannungswandler nach Anspruch 4, **dadurch gekennzeichnet, dass** der Spannungsteiler ($R_1$, $R_2$, 132) zumindest einen Transistor (132, FET1, FET2, FET3...FET$_n$) beinhaltet, welcher eine Schwellenspannung ($V_T$) aufweist, die im Wesentlichen der des Schalttransistors (112, 212) entspricht.

**7.** Spannungswandler nach Anspruch 4, **dadurch gekennzeichnet, dass** der Spannungsteiler ($R_1$, $R_2$, 132, FET1, FET2, FET3...FET$_n$) wenigstens einen Transistor "=" mit einem Source- (114) und einem Drain-Anschluss (136) aufweist, und der Schalttransistor (112, 212) einen Source- (111) und einen Drain-Anschluss (113) aufweist, wobei die Source- (144, 111) und Drain-Anschlüsse (136, 113) sich dotierte Bereiche teilen.

**8.** Spannungswandler nach Anspruch 1 oder 2, **gekennzeichnet durch** eine Regelungsschaltung (314), welche

einen ersten Verzweigungsknoten (326);

einen zweiten Verzweigungsknoten zum Anschluss an einen Gate-Anschluss des Schalttransistors (312); und einen Rückkopplungsschalter (354) umfasst, welcher mit dem ersten und dem zweiten Verzweigungsknoten (326, 324) verbunden ist, um Spannungsschwankungen am ersten Verzweigungsknoten (326) zu detektieren und zur Regelung der Spannung an dem zweiten Verzweigungsknoten (324), um Änderungen im Strom **durch** den Schalttransistor (312) zu kompensieren.

**9.** Spannungswandler nach Anspruch 8, **dadurch gekennzeichnet, dass** der Rückkopplungsschalter (354) einen Differenzverstärker (310) umfasst, um eine im Wesentlichen konstante Spannung ($V_{REF'}$) für den ersten Verzweigungsknoten (326) bereit zu stellen, wobei ein Widerstand ($R_3$) so zwischen dem ersten Verzweigungsknoten (326) und der Masse angebracht ist, dass ein konstanter Strom ($I_2$) durch den ersten Transistor (332) fließt, und wobei der erste Transistor (332) einen Gate-Anschluss (336) aufweist, welcher mit dem zweiten Verzweigungsknoten (324) verbunden ist.

**10.** Spannungswandler nach Anspruch 9, **dadurch gekennzeichnet, dass** der erste Transistor (332) und der Schalttransistor (312) PMOSFETs sind.

**11.** Spannungswandler nach Anspruch 9, **dadurch gekennzeichnet, dass** der erste Transistor (332) und der Schalttransistor (312) NMOSFETs sind.

**12.** Spannungswandler nach den Anspruchen 9, 10 oder 11, **dadurch gekennzeichnet, dass** der erste Transistor (332) eine Schwellenspannung ($V_T$) aufweist, welche im Wesentlichen der Schwellenspannung ($V_T$) des Schalttransistor (312) entspricht.

**13.** Spannungswandler nach einem der Ansprüche 9 bis 12, **dadurch gekennzeichnet, dass** der erste Transistor (332) einen Source- (334) und einen Drain-Anschluss (328) aufweist, wobei der Schalttransistor (312) einen Source-(311) und Drain-Anschluss (313) aufweist, bei denen sich die Source- (334, 311) und Drain-Anschlüsse (328, 313) dotierte Bereiche teilen.

**14.** Spannungswandler nach einem der Ansprüche 1 bis 13, **dadurch gekennzeichnet, dass** der Spannungswandler ein Abwärts-Spannungswandler einer Halbleiterspeichereinrichtung ist.

**15.** Halbleiterspeicher mit einem Spannungswandler gemäß einem der vorhergehenden Ansprüche.

**Revendications**

**1.** Circuit transformateur de tension comprenant :

- un commutateur à transistor (12, 112, 212, 312) fournissant des impulsions de courant à un noeud d'entrée de courant (20, 120, 220, 320), le commutateur à transistor (12, 112, 212, 312) ayant une porte (22, 122, 309) et une tension de seuil de déblocage ($V_T$),

**caractérisé par**

- un circuit de réglage (14, 114, 214, 314) fournissant une tension commandée à la porte (22, 122, 309) pour débloquer le commutateur à transistor (12, 112, 212, 312) ainsi qu'un moyen pour compenser les variations ($\Delta V_T$) de la tension de seuil de déblocage ($V_T$) du commutateur à transistor (12, 112, 212, 312) et,
- une horloge (16) autorisant le circuit de réglage (14, 114, 214, 314) pendant une période de temps prédéterminée.

2. Circuit transformateur de tension selon la revendication 1,
   **caractérisé en ce que**
   le commutateur à transistor (12, 112, 212, 312) est un MOSFET (12, 112, 212, 312).

3. Circuit transformateur de tension selon la revendication 1,
   **caractérisé en ce que**
   le circuit de réglage (114, 214) comporte un transistor (132, FET1, FET2. FET3...FET$_n$) ayant un seuil de tension de déblocage ($V_T$) sensiblement égal au seuil de tension de déblocage ($V_T$) du commutateur à transistor (112, 212).

4. Circuit transformateur de tension selon la revendication 1,
   **caractérisé en ce que**
   le circuit de réglage (114, 214) comporte un circuit diviseur de tension ($R_1$, $R_2$, 132, FET1. FET2, FET3...FETn).

5. Circuit transformateur de tension selon la revendication 4,
   **caractérisé en ce que**
   le circuit diviseur de tension ($R_1$, $R_2$, 132, FET1. FET2, FET3...FETn) comporte au moins une résistance ($R_1$, $R_2$) dimensionnée pour régler la tension de porte ($V_{noeud124}$, $V_{noeud224}$) du commutateur à transistor (112, 212).

6. Circuit transformateur de tension selon la revendication 4,
   **caractérisé en ce que**
   le circuit diviseur de tension ($R_1$, $R_2$, 132) comporte au moins un transistor [132, FET1, FET2. FET3...FET$_n$) ayant une tension de seuil ($V_T$) sensiblement la même que celle du commutateur à transistor (112, 212).

7. Circuit transformateur de tension selon la revendication 4.
   **caractérisé en ce que**
   le circuit diviseur de tension ($R_1$, $R_2$, 132, FET1, FET2, FET3...FETn) comporte au moins un transistor (132, FET1, FET2, FET3...FET$_n$) ayant une source (114) et un drain (116). le commutateur à transistor (112, 212) ayant une source (111) et un drain (113). les sources (144, 111) et les drains (136, 113) partageant des régions dopées.

8. Circuit transformateur de tension selon les revendications 1 ou 2,
   **caractérisé en ce que**
   le circuit de réglage (314) comprend :

   - un premier noeud (326),
   - un second noeud pour relier la porte du commutateur à transistor (312).
   - un circuit de réaction (354) relié au premier et au second noeuds (326, 324) pour contrôler les variations de tension du premier noeud (326) et régler la tension sur un second noeud (324) et compenser les variations de courant traversant le commutateur à transistor (312).

9. Circuit transformateur de tension selon la revendication 8,
   **caractérisé en ce que**
   le circuit de réaction (354) comporte un amplificateur différentiel (310) fournissant une tension pratiquement constante ($V_{REF}'$) au premier noeud (326), une résistance ($R_3$) étant branchée entre le premier noeud (326) et la masse de façon qu'un courant constant ($I_2$) traverse un premier transistor (332), ce dernier ayant une porte (336) reliée au second noeud (324).

**10.** Circuit transformateur de tension selon la revendication 9,
**caractérisé en ce que**
le premier transistor (332) et le commutateur à transistor (312) sont des PMOSFET.

**11.** Circuit transformateur de tension selon la revendication 9,
**caractérisé en ce que**
le premier transistor (332) et le commutateur à transistor (312) sont des NMOSFET.

**12.** Circuit transformateur de tension selon l'une des revendications 9, 10 ou 11,
**caractérisé en ce que**
le premier transistor (332) présente une tension de seuil ($V_T$) pratiquement égale à la tension de seuil ($V_T$) du commutateur à transistor (312).

**13.** Circuit transformateur de tension selon l'une des revendications 9 à 12,
**caractérisé en ce que**
le premier transistor (332) a une source (334) et un drain (328), le commutateur à transistor (312) a une source (311) et un drain (313), les sources (334, 311) et les drains (328, 313) partageant des régions dopées.

**14.** Circuit transformateur de tension selon l'une des revendications 1 à 13,
**caractérisé en ce qu'**
il est constitué par un convertisseur abaisseur de tension à dispositif à mémoire serni-conductrice.

**15.** Mémoire semi-conductrice comportant un circuit convertisseur de tension selon l'une des revendications précédentes.

FIG. 1
(PRIOR ART)

FIG. 2

EP 0 905 898 B1

*FIG. 3*

FIG. 4

EP 0 905 898 B1

FIG. 5

EP 0 905 898 B1

14